# FASCICULE DE BREVET EUROPEEN

(11) **EP 1 959 266 B1**
(45) Date de publication et mention de la délivrance du brevet: **20.01.2010**
(21) Numéro de dépôt: 08101492.0
(22) Date de dépôt: 11.02.2008
(51) Int. Cl.: G01R 31/3185, G01R 31/3187

(54) **Circuit intégré, procédé de test, dispositif et programme d'ordinateur correspondants.**
Integrierter Schaltkreis, Testverfahren sowie dazugehörige Vorrichtung und dazugehöriges Computerprogramm
Integrated circuit, test method, corresponding computer program and device

(30) Priorité: 13.02.2007 FR 0701094
(43) Date de publication de la demande: 20.08.2008
(73) Titulaire: Compagnie Industrielle et Financiere d'Ingenierie Ingenico, 92220 Neuilly sur Seine (FR)
(72) Inventeur: NACCACHE, David, 75018, PARIS (FR)
(74) Mandataire: Bioret, Ludovic

(56) Documents cités:
- US-A1- 2003 172 333
- GIZOPOULOS D ET AL: "A Concurrent Built-In Self-Test Architecture Based on a Self-Testing RAM" IEEE TRANSACTIONS ON RELIABILITY, IEEE SERVICE CENTER, PISCATAWAY, NJ, US, vol. 54, no. 1, mars 2005 (2005-03), pages 69-78, XP011127656 ISSN: 0018-9529

## Description

### 1. Domaine de l'invention

Le domaine de l'invention est celui des circuits intégrés, et plus précisément des tests de tels circuits.

Par circuit intégré, on entend notamment les systèmes électroniques intégrés tels que les puces électroniques ou microprocesseurs. Notamment, l'invention concerne les tests effectués en fin de fabrication de tels circuits, avant leur commercialisation ou leur mise en fonction.

### 2. Art antérieur

Il existe déjà des méthodes de test de circuits intégrés électroniques qui permettent de mesurer leur qualité et leur fiabilité, de manière à augmenter leur rendement de production.

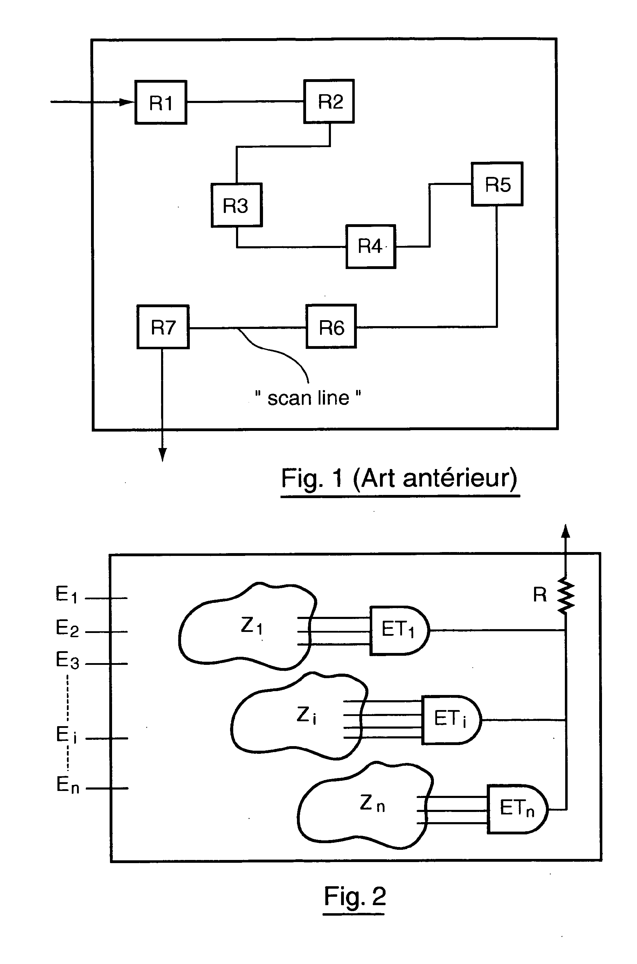

Par exemple, une technique connue de test de circuits intégrés, illustrée en figure 1, consiste à relier tous les registres (séquenceurs, compteurs, "RAM" ("Random Access Memory")...) présents dans une puce ou un circuit électronique intégré, par l'intermédiaire d'une "scanline" (la sortie d'un registre étant connectée à l'entrée du registre suivant), puis à faire fonctionner le circuit, pour en observer l'état final après interruption de son fonctionnement à un instant prédéfini.

L'état du circuit est alors obtenu en "scannant" tous les registres (notés R1 ... R7), c'est-à-dire en les vidant les uns à la suite des autres (via la « scanline »), pour obtenir une suite d'états. Cette suite d'états est ensuite comparée à une suite d'états de référence, attendue pour le circuit testé.

Une telle technique est par exemple présentée dans le document de brevet US 2003/172333, dans lequel sont décrits un système et un procédé de programmation de circuit de type "Built-In Self-Testing" (BIST) pour tester des composants de circuit intégré, basés sur la connection en parallèle des registres de stockage des instructions de test "BIST".

Un inconvénient majeur de cette technique réside dans le fait que la connexion de tous les registres nécessite une mise en oeuvre lourde et complexe, nécessitant une connectique dédiée.

De plus, la "scanline" reliant tous les registres sépare le circuit en deux parties et rend plus complexe l'implantation des composants élémentaires dans ce circuit, en empêchant certaines connexions entre des composants se trouvant de part et d'autre de cette liaison (ou nécessite la mise en oeuvre de moyens spécifiques (« ponts ») pour franchir cette liaison, ou « frontière » entre les deux parties).

### 3. Objectifs de l'invention

L'invention a notamment pour objectif de pallier au moins certains de ces inconvénients de l'art antérieur.

Plus précisément, un objectif de l'invention, selon au moins un mode de réalisation, est de fournir une technique de test de circuits intégrés électroniques, simple et efficace, ne nécessitant notamment pas la présence d'une « scanline ».

Notamment, l'invention a pour objectif de fournir une telle technique présentant de meilleures performances en termes de connectique à mettre en oeuvre pour tester des composants élémentaires d'un circuit intégré.

Un autre objectif de l'invention est de fournir une telle technique, qui soit efficace en termes de détection et de localisation d'éventuels défauts sur un circuit électronique et en termes de temps nécessaire à de telles détections et localisations.

Un autre objectif de l'invention est de fournir une telle technique, qui puisse être mise en oeuvre à coût réduit et qui permette un contrôle rapide, en quelques secondes.

Encore un objectif de l'invention est de fournir une telle technique permettant de vérifier que le test des composants a bien été effectué.

### 4. Exposé de l'invention

L'invention propose une solution nouvelle qui ne présente pas au moins certains de ces inconvénients de l'art antérieur, sous la forme d'un circuit intégré comprenant au moins une entrée externe, une alimentation, et une pluralité de composants élémentaires, présentant chacun au moins une entrée interne et au moins une sortie interne.

Selon l'invention, un tel circuit comprend au moins une unité de test comprenant une porte ET, dont chaque entrée est connectée à une sortie interne d'un desdits composants élémentaires et dont la sortie est reliée à ladite alimentation, via une résistance.

Ainsi, l'invention permet de tester les composants élémentaires intégrés sur un circuit et de détecter les composants défectueux sur ce circuit intégré, en mettant en oeuvre une ou plusieurs unités de test correspondant au test de plusieurs composants élémentaires du circuit, et en lisant le résultat du test au niveau de l'alimentation, par exemple en suivant les variations de celles-ci.

Selon un mode de réalisation avantageux, lesdites sorties internes connectées auxdites entrées de la porte ET sont sélectionnées de façon que ladite porte ET délivre un « 1 » si lesdits composants élémentaires de l'unité de test considéré sont conformes, dans une configuration de test dans laquelle une séquence de test prédéterminée est injectée via la ou lesdites entrées externes.

En effet, un principe du procédé de test selon l'invention repose sur l'injection dans le circuit d'une séquence de test pour chaque unité de test, permettant de détecter si au moins un composant élémentaire est défectueux, en fonction de la valeur de la sortie de la porte ET de chaque unité de test.

Autrement dit, on injecte, pour une unité de test, via la ou les entrées externes du circuit intégré, une séquence de test amenant, après traitement, les états souhaités (si le composant est conforme) aux entrées des composants élémentaires à tester. Les sorties de ces composants internes sont reliées aux entrées d'une porte ET, et doivent valoir « 1 » si tout est correct. On attend donc en sortie de la porte ET un "1" si les composants sont conformes, un "0" si au moins un des composants est défectueux.

Une configuration de test correspond donc à l'injection d'une séquence de test prédéterminée permettant d'avoir un "1" en sortie de la porte ET de l'unité de test observée si les composants testés sont conformes.

On peut bien sûr prévoir qu'au moins une des entrées de la porte ET présente un inverseur, de façon que l'ensemble desdites entrées valent « 1 » dans ladite configuration de test.

En fonction de la séquence de test injectée, certaines sorties internes de certains des composants peuvent en effet être égales à "0" et sont ainsi inversées pour présenter des valeurs "1" aux entrées de la porte ET.

Selon un aspect avantageux de l'invention, le circuit intégré comprend au moins deux unités de test, associées chacune à une zone distincte dudit circuit.

Ainsi, le circuit intégré présente plusieurs zones, comprenant chacune un ou plusieurs composants élémentaires. Chaque zone comprend également une unité de test telle que décrite précédemment.

Lesdites entrées de chacune desdites unités de test sont préférentiellement préselectionnées de façon qu'une configuration de test dédiée soit associée à chaque unité de test, pour permettre un test indépendant de chacune desdites zones.

Ainsi, à chaque zone du circuit correspond une unité de test dédiée et une séquence de test dédiée également. Cela permet de tester les composants élémentaires du circuit par groupe (par zone), chaque zone étant testée successivement, en mettant en oeuvre une configuration de test dédiée, pour permettre de localiser les éventuels composants défectueux.

Chaque configuration de test permet donc, si tous les composants élémentaires du circuit sont conformes, de faire passer successivement chaque porte ET de chaque unité de test à "1". La configuration de test d'une unité est choisie de façon que les autres unités de test délivre un « 0 ».

Selon un aspect particulier de l'invention, un tel circuit intégré comprend avantageusement des moyens d'inactivation de la ou desdites unités de test.

Ainsi, les unités de test du circuit peuvent être désactivés, par exemple pour permettre au circuit de se mettre en état de fonctionnement "normal". Cette désactivation du mode de test du circuit peut être mise en oeuvre notamment pour des raisons de sécurité et de fiabilité. En effet, le mode de test du circuit est un mode entraînant une surconsommation de courant, qui peut s'avérer problématique, voire dangereuse en mode de fonctionnement normal, notamment dans le cas de circuits particuliers (par exemple, un circuit implanté dans un stimulateur cardiaque).

Selon un autre aspect de l'invention, au moins un desdits moyens d'inactivation d'au moins une desdites unités de test comprend une porte OU, dont une première entrée interne est connectée à la sortie de la porte ET de ladite unité de test, une seconde entrée interne est connectée à un signal de commande d'inactivation, et la sortie est connectée à ladite résistance.

Ainsi, l'injection du signal de commande d'inactivation permet de faire passer systématiquement la sortie de la porte OU à "1", et donc de neutraliser l'unité de test.

Selon un autre mode de réalisation de l'invention, ledit signal de commande d'inactivation est délivré par un fusible interne, qui disjoncte une fois pour toute à réception d'un signal de disjonction délivré par la sortie d'une porte ET d'inactivation, dont les entrées reçoivent une séquence prédéterminée d'inactivation de test.

Ainsi, une fois le test de toutes les zones du circuit effectué, on peut désactiver de façon définitive les unités de test, en faisant disjoncter les différents fusibles, de façon à mettre le circuit en mode de fonctionnement normal. Selon une autre approche, un fusible général peut être prévu, désactivant l'ensemble des unités de test.

De façon préférentielle, un tel circuit comprend des moyens de vérification d'inactivation de test comprenant une porte ET dont les entrées sont connectées aux bornes dudit fusible, et la sortie est reliée à ladite alimentation, via une seconde résistance.

Ainsi, on peut vérifier à tout moment que les unités de test ont été désactivées et que le circuit peut fonctionner normalement. On s'assure ainsi qu'un circuit dont le mode de test n'a pas été désactivé n'est pas mis sur le marché.

Un autre aspect de l'invention concerne un procédé de test d'un circuit intégré réalisé tel que décrit précédemment.

Selon l'invention, un tel procédé de test d'un circuit intégré comprend une phase de test comprenant, pour au moins une unité de test, les étapes suivantes :
- envoi d'une séquence de test prédéterminée via au moins une desdites entrées externes dudit circuit intégré ;
- observation du courant dans ladite résistance ;
- décision de conformité délivrant une information de conformité ou de non conformité pour ladite zone, en fonction de ladite observation.

Ainsi, il est possible de tester simplement et efficacement un circuit tel que décrit précédemment, en mesurant le courant au niveau de l'alimentation.

Le principe du procédé de test selon l'invention consiste en effet, pour une unité de test correspondant à une zone à tester du circuit intégré, à envoyer une séquence de test prédéterminée via au moins une desdites entrées externes dudit circuit intégré, puis à observer le courant dans la résistance de l'unité de test et enfin à délivrer une information de conformité ou de non conformité pour la zone en question, en fonction de ladite observation.

Ainsi, l'observation du courant dans la résistance permet de prendre en compte les comportements des composants élémentaires de la zone à tester en réponse à l'injection d'une séquence de test dédiée à cette zone pour détecter si un ou plusieurs des composants de la zone à tester est défectueux.

Le procédé selon l'invention délivre une information de conformité correspondant au test d'une zone du circuit.

Préférentiellement, lorsque le circuit comprend plusieurs zones, ladite phase de test est mise en oeuvre successivement pour chaque zone dudit circuit et le procédé de test délivre une information de conformité globale pour ledit circuit ou une information de non conformité identifiant au moins une zone défaillante dudit circuit.

Ainsi, le procédé de test selon l'invention met en oeuvre les différentes étapes de la phase de test pour chaque zone à tester, en utilisant chaque unité de test ajoutée au circuit. De cette manière, le procédé de test permet de délivrer une décision globale de conformité du circuit, en prenant en compte les différentes informations de conformité successives obtenues pour chaque zone du circuit.

Selon un aspect particulier, le procédé de test s'arrête dès qu'une erreur est détectée, c'est-à-dire dès qu'une phase de test a délivré une information de non conformité.

En effet, un tel circuit intégré est souvent jugé inutilisable et surtout non "réparable" si un de ces composants est défectueux. Pour une plus grande rapidité de test, il est alors préférable d'arrêter le procédé de test dès qu'une erreur est détectée.

Par contre, si l'on souhaite localiser l'erreur, par exemple pour recenser et faire des statistiques sur les composants défectueux, il peut alors être préférable de continuer à tester les zones restantes du circuit, afin de bénéficier à la fin de la localisation de la ou des zones défectueuses.

Selon un aspect particulier de l'invention, le procédé comprend une étape d'inactivation de test permettant de neutraliser la consommation de courant dans ladite résistance, après ladite phase de test.

Ainsi, une fois le test effectué et le circuit validé comme ne comportant pas de composants défectueux, le procédé selon l'invention peut désactiver les unités de test, en neutralisant la circulation de courant dans la résistance, et ainsi mettre le circuit en état de fonctionnement normal. Cette étape d'inactivation correspond par exemple à un circuit dans lequel circule un signal de commande d'inactivation de test.

Préférentiellement, ladite étape d'inactivation comprend une étape d'envoi d'une séquence d'inactivation.

Dans ce cas, qui correspond à un circuit dans lequel est ajouté un fusible générant un signal de commande d'inactivation de test, une séquence d'inactivation est envoyée, par exemple via des sorties externes du circuit, pour faire disjoncter le fusible en question.

Selon cet aspect particulier, un tel procédé comprend une étape de vérification d'inactivation de test comprenant les sous-étapes suivantes :
- répétition de ladite étape d'inactivation de test,
- observation du courant dans ladite résistance.

Ainsi, le procédé peut également vérifier que les éléments mis en oeuvre pour le test sont désactivés, en vérifiant qu'un deuxième envoi d'une séquence d'inactivation de test n'a pas d'effet quand le mode de test a bien été précédemment désactivé.

L'invention concerne également un dispositif de test d'un circuit intégré réalisé tel que décrit précédemment.

En particulier, un tel dispositif comprend, pour une unité de test correspondant à une desdites zones dudit circuit, des moyens de test comprenant :
- des moyens d'envoi d'une séquence de test prédéterminée via au moins une desdites entrées externes dudit circuit intégré ;
- des moyens d'observation du courant dans ladite résistance ;
- des moyens de décision de conformité délivrant une information de conformité ou de non conformité pour ladite zone, en fonction de ladite observation.

En particulier, un tel dispositif est apte à mettre en oeuvre le procédé de test décrit précédemment.

Finalement, l'invention concerne également les programmes d'ordinateur téléchargeables depuis au moins un réseau de communication et/ou enregistrés sur un support lisible par ordinateur et/ou exécutables par un processeur, comprenant des instructions de code de programme pour la mise en oeuvre du procédé de test décrit précédemment.

### 5. Liste des figures

D'autres caractéristiques et avantages de l'invention apparaîtront plus clairement à la lecture de la description suivante d'un mode de réalisation particulier, donné à titre de simple exemple illustratif et non limitatif, et des dessins annexés, parmi lesquels :
- la figure 1, déjà commentée en relation avec l'art antérieur, illustre un exemple de technique de test de circuits intégrés selon l'art antérieur, présentant une "scanline" ;
- la figure 2 présente un exemple d'un circuit intégré selon un mode de réalisation particulier de l'invention ;
- la figure 3 présente les différentes étapes du procédé, pour une zone d'un circuit intégré tel qu'illustré en figure 2, selon un mode de réalisation particulier de l'invention ;
- la figure 4 présente un exemple d'une zone d'un circuit intégré pour le test des composants élémentaires de cette zone selon un mode de réalisation particulier de l'invention ;
- la figure 5 est un organigramme simplifié illustrant le principe général de l'invention pour un circuit intégré, selon un mode de réalisation particulier de l'invention ;
- la figure 6 illustre un exemple d'une zone d'un circuit intégré pour le test et l'inactivation du test des composants élémentaires de cette zone selon un premier mode de réalisation de l'invention ;
- la figure 7 illustre un exemple d'une zone d'un circuit intégré pour le test et l'inactivation du test des composants élémentaires de cette zone selon un deuxième mode de réalisation de l'invention ;
- la figure 8 illustre un exemple d'une zone d'un circuit intégré pour le test, l'inactivation du test des composants élémentaires de cette zone et la vérification de l'inactivation du test selon le deuxième mode de réalisation de l'invention.

### 6. Description d'un mode de réalisation de l'invention

### 6.1 Aspects généraux

Le principe général de l'invention repose sur l'analyse du comportement électrique d'une ou plusieurs zones ou parties définies d'un circuit intégré, en réponse à une sollicitation par l'intermédiaire d'une ou plusieurs entrées externes de ce circuit, notées E₁, E₂,..., Eᵢ,..., Eₙ sur la figure 2.

L'invention propose notamment un procédé de test et un dispositif de test correspondant, ainsi que des circuits intégrés spécifiques, permettant la mise en oeuvre de ce procédé et de ce dispositif.

Le procédé de test selon l'invention détermine les différentes zones à tester du circuit, de manière à pouvoir localiser une éventuelle erreur détectée.

Comme décrit en relation avec la figure 2, le circuit intégré à tester présente plusieurs zones à tester Z₁, Z₂,..., Zᵢ,..., Zₙ.

On décrit tout d'abord la mise en oeuvre du procédé, et le circuit correspondant, pour une zone Zᵢ du circuit, et ensuite l'intégration du procédé dans chaque zone du circuit pour un résultat global sur la fiabilité, ou la conformité, du circuit complet.

### 6.2 Test des composants élémentaires sur une zone du circuit

Le principe du test repose notamment sur la connaissance a priori du comportement logique attendu de chaque composant de la zone du circuit testée, en réponse à une sollicitation particulière.

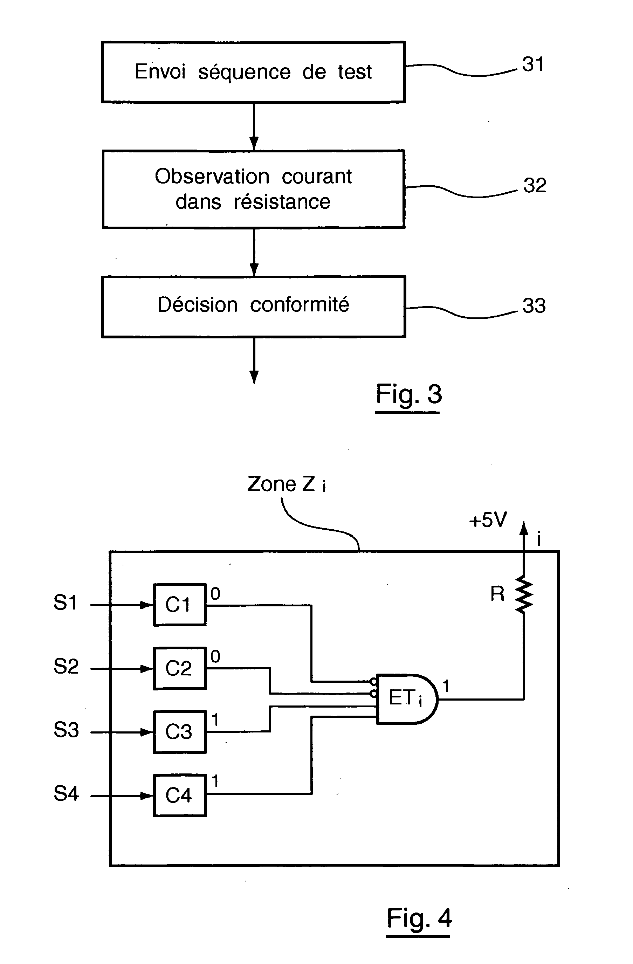

Comme illustré en figure 3, la première étape 31 consiste donc à injecter une séquence de test, par l'intermédiaire des entrées externes du circuit, aux entrées des composants appartenant à une zone à tester.

Cette séquence de test entraîne un comportement particulier du circuit, et un état final particulier de chacun des composants de la zone à tester, qui présentent donc à leur sortie un état logique particulier, et attendu.

Ces différentes sorties sont connectées aux entrées d'une porte logique ET, appelée par la suite "ETᵢ", ajoutée au circuit intégré pour la mise en oeuvre du procédé de test (comme décrit plus bas en relation avec la figure 4).

La sortie de cette porte "ETᵢ" est connectée à une résistance R, elle-même reliée à l'alimentation du circuit, comme présenté ci-dessous en relation avec la figure 4.

La deuxième étape 32 du procédé selon ce mode de réalisation particulier de l'invention consiste à observer le courant dans cette résistance, pour délivrer ensuite une décision de conformité lors d'une étape 33.

Ces différentes étapes sont détaillées ci-dessous, en relation avec la figure 4, qui présente une zone "Zᵢ" à tester, selon un mode de réalisation particulier de l'invention.

On précise que dans un tel circuit, un état logique "1" correspond à une tension égale à +5V (plus généralement à la tension d'alimentation), et un état logique "0" correspond à une tension égale à 0V.

On considère donc par exemple, dans une zone Zᵢ, un premier composant C1 prenant l'état logique "0" en réponse à une première sollicitation S1, un deuxième composant C2 prenant l'état logique "0" en réponse à une deuxième sollicitation S2, un troisième composant C3 prenant l'état logique "1" en réponse à une troisième sollicitation S3 et un quatrième composant C4 prenant l'état logique "1" en réponse à une quatrième sollicitation S4.

Les états logiques attendus des sorties respectives des quatre composants, en réponse à une séquence de test comprenant les quatre sollicitations précédemment définies "S1 S2 S3 S4", forment la suite d'états "0 0 1 1".

Ces états sont pris en compte pour déterminer les quatre entrées d'une porte logique "ET" notée "ETᵢ", de façon à ce que la sortie de cette porte "ETᵢ" soit égale à "1" si les états des quatre composants sont les états attendus, en réponse à la séquence de test prédéterminée, et à "0" si au moins un des états des quatre composants n'est pas l'état attendu.

Le cas échéant, un inverseur permet de transformer une sortie « 0 » d'un composant en une entrée de la porte « ET » valant « 1 ».

On relie ensuite la sortie de cette porte "ETᵢ" à une résistance R, elle-même connectée à l'alimentation du circuit.

On observe maintenant les variations de courant i dans la résistance R. Deux cas se présentent :
- si la sortie de la porte "ETᵢ" est égale à " 1 "(cas où les états de tous les composants correspondent à ceux attendus), la résistance R se retrouve connectée entre 2 valeurs de potentiel identiques (ici +5V), et on n'observe aucune circulation de courant dans R ;
- si la sortie de la porte "ETᵢ" est égale à "0" (cas où au moins un des états des composants ne correspond pas à celui attendu), la résistance R se retrouve connectée entre 0V et +5V, ce qui induit une circulation de courant non nulle dans R.

Ainsi, en observant la circulation de courant i dans la résistance R, on peut détecter une erreur dans la zone de circuit concernée "Zᵢ", car si la consommation de courant dans R augmente en réponse à la séquence de test, on en déduit qu'un des composants testés ne se comporte pas comme attendu.

Par contre, si la consommation de courant dans R ne varie pas de manière significative, on en déduit que tous les composants testés, dans la zone "Zᵢ", se comportent comme attendu.

Les variations de courant dans R sont évaluées en fonction d'un seuil, au delà duquel le procédé de test décide qu'une erreur est détectée dans la zone de circuit testée.

Ce seuil peut être déterminé par exemple en fonction des performances attendues du procédé de test de composants.

### 6.3 Test des composants élémentaires du circuit complet

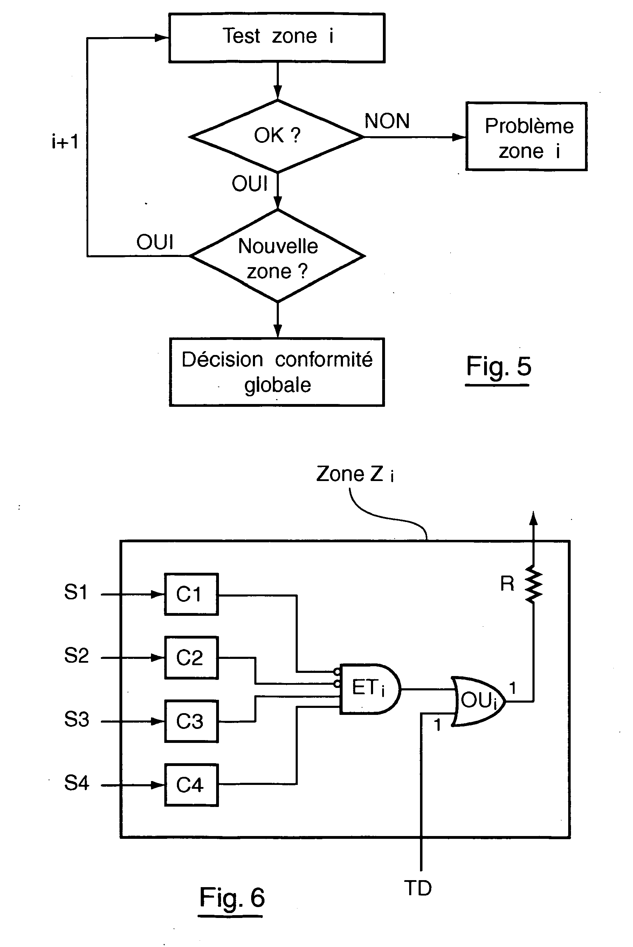

Les étapes décrites ci-dessus sont répétées autant de fois que le circuit comporte de zones différentes, de façon à pouvoir effectuer un test global du circuit, selon l'organigramme simplifié de la figure 5.

Les séquences de test et les portes logiques "ETᵢ" de chacune des zones sont choisies de manière à permettre la localisation des éventuelles erreurs détectées, de manière à ce que les sorties des différentes portes "ETᵢ" ne soient pas égales à "1" en même temps, mais successivement.

En d'autres termes, le "découpage", ou l'organisation, du circuit en plusieurs zones à tester peut être défini de manière à pouvoir déterminer les séquences de test correspondantes, qui, lorsqu'elles sont émises successivement dans le circuit, permettent de faire passer à 1 successivement chacune des portes "ETᵢ" de test et ainsi de détecter une éventuelle erreur dans une ou plusieurs zones du circuit.

Comme illustré en figure 5, une première zone (i=1) du circuit intégré est testée, selon les deux premières étapes 31 et 32 du procédé selon l'invention, comme décrit précédemment en relation avec la figure 3.

Le procédé selon l'invention délivre une décision de conformité pour la zone 1 testée, indiquant :
- soit un problème pour la zone 1 ;
- soit une information de conformité pour la zone 1.

Dans le premier cas, le procédé de test selon l'invention peut :
- soit stopper le test du reste du circuit dès qu'un problème est détecté (en effet, en général, de tels circuits ne sont pas "réparables" et sont donc considérés comme inutilisables si un des composants est défectueux) ;
- soit continuer le test du reste du circuit, en mémorisant les zones dans lesquelles un problème a été détecté pour un recensement global des différentes erreurs en fin de test (cette solution peut être utile dans le but de faire des statistiques sur la fiabilité des composants par exemple, si des composants sont identifiés comme étant souvent défectueux).

Une fois la première zone testée, le procédé selon l'invention détecte si le circuit présente une deuxième zone à tester (i=2).

Si cela n'est pas le cas, une décision globale de conformité du circuit est délivrée, sinon, la zone suivante du circuit est testée, selon les étapes précédemment décrites, et ainsi de suite pour toutes les zones du circuit intégré.

Ainsi, quand toutes les zones du circuit ont été testées, le procédé de test selon l'invention peut délivrer une décision globale de conformité du circuit, par exemple sous les formes suivantes :
- si toutes les parties testées sont conformes, la décision globale correspond à une information de conformité du circuit ;
- si au moins une des parties testées n'est pas conforme, la décision globale correspond :
   ■ soit à une information de non conformité du circuit, comprenant l'identification de la première zone non conforme;
   ■ soit à une information de non conformité du circuit, comprenant l'identification de toutes les zones non conformes ;
   ■ soit simplement à une information de non conformité du circuit.

### 6.4 Activation /désactivation du test

### 6.4.1 Neutralisation du circuit de test

Selon différents modes de réalisation particuliers de l'invention, les éléments mis en oeuvre pour la réalisation du procédé de test décrit ci-dessus peuvent être activés ou non, selon que le circuit fonctionne en mode de test ou en mode de fonctionnement "normal", c'est à dire dans l'utilisation pour lequel il a été fabriqué.

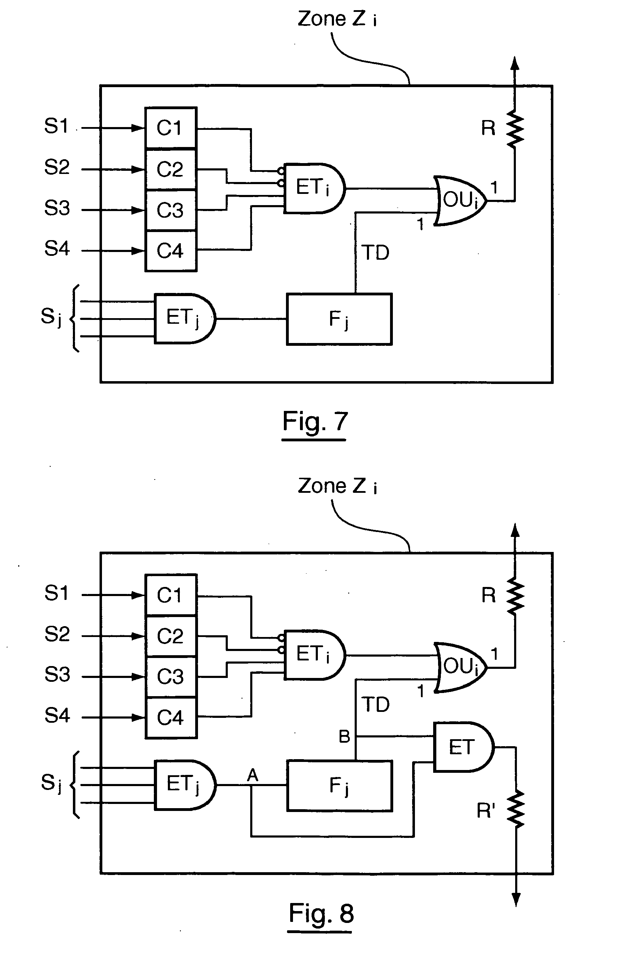

Pour cela, on présente ci-après deux modes de réalisation particuliers, respectivement en relation avec les figures 6 et 7.

Dans ces deux modes de réalisation, le principe d'inactivation du circuit de test consiste à neutraliser la consommation de courant dans la résistance R en sortie des portes "ETᵢ" de test.

En effet, la technique de test de composants selon l'invention étant basée sur l'observation de la consommation de courant dans cette résistance R, le fait de neutraliser cette consommation de courant permet de neutraliser le circuit de test quand on le souhaite, c'est-à-dire quand le circuit se trouve en mode de fonctionnement normal.

Pour ce faire, on propose, comme illustré en figures 6 et 7, d'ajouter, en sortie de chaque porte "ETᵢ"de test, une porte "OUᵢ", qui, grâce à un signal de commande d'inactivation, appelé par exemple TD ("Test Disable"), présente toujours une sortie égale à "1", neutralisant ainsi la circulation de courant dans la résistance R.

### 6.4.1.1 premier mode de réalisation

Selon un premier mode de réalisation, en relation avec la figure 6, le signal TD peut être injecté par l'intermédiaire d'une entrée externe du circuit et circule dans le circuit de manière non linéaire, permettant ainsi de ne pas le partitionner.

L'injection de ce signal permet de neutraliser l'ensemble du circuit de test.

### 6.4.1.2 deuxième mode de réalisation

Selon un deuxième mode de réalisation, illustré en figure 7, la porte "OUᵢ" a pour deuxième entrée un fusible "Fⱼ".

Lorsque ce fusible "Fⱼ" disjoncte ou "saute", il présente une sortie égale à "1", permettant à la porte "OUᵢ" de présenter elle aussi une sortie égale à "1" et de neutraliser ainsi la circulation de courant dans la résistance R.

Le fusible "Fⱼ" peut être par exemple une cellule de mémoire non volatile, disjonctant quand on lui présente une entrée égale à 1.

Dans ce mode de réalisation, cette entrée du fusible "Fᵢ" est la sortie d'une autre porte "ETⱼ", appelée "porte ET d'extinction de test", présentant une sortie égale à "1" en réponse à une sollicitation particulière "Sⱼ", appelée sollicitation d'extinction de test, déterminée pour permettre la neutralisation du circuit de test (c'est-à-dire l'ensemble des unités de test), quand on veut passer le circuit du mode de test à un mode de fonctionnement normal.

Ainsi, pour passer le circuit du mode de test au mode de fonctionnement normal, on injecte les signaux de la sollicitation d'extinction de test "Sⱼ", ce qui fait disjoncter les fusibles "Fⱼ" et neutralise ainsi le circuit de test.

Selon une variante de ce mode de réalisation, on peut envisager qu'une même séquence d'extinction de test permette de neutraliser le circuit de test entier, c'est-à-dire fasse disjoncter tous les fusibles "Fⱼ" en même temps.

Selon une autre variante, un seul fusible peut être utilisé pour neutraliser l'ensemble du circuit de test.

### 6.4.2 Vérification de la neutralisation du circuit de test

Il est également possible, selon le procédé de test de l'invention, comme illustré en figure 8, de s'assurer que le circuit de test est bien neutralisé, notamment dans le deuxième mode de réalisation de la neutralisation du test décrit ci-dessus.

Le principe est de tester si le fusible "Fⱼ" a effectivement disjoncté, en observant les signaux aux points A et B, c'est à dire en entrée et en sortie du fusible "Fⱼ" en question.

Pour ce faire, on ajoute une porte ET prenant en entrées ces deux signaux aux points A et B, et une seconde résistance R' dans laquelle on observe la circulation de courant.

Quand on veut passer en mode de fonctionnement normal, on injecte dans le circuit la sollicitation d'extinction de test "Sⱼ", ce qui se traduit par un signal au point B égal à "1".

Quand le fusible "Fⱼ" n'a pas disjoncté, le signal en A est donc égal à "0".

Dans ce cas, la seconde résistance R' se retrouve connectée entre 0V et +5V, ce qui induit une circulation de courant non nulle.

Quand le fusible "Fⱼ" disjoncte, on observe une variation de la circulation de courant dans la résistance R'.

Si on injecte à nouveau, une fois que le fusible "Fⱼ" a disjoncté, la sollicitation d'extinction de test "Sⱼ", le signal aux points A et en B est identique et égal à "1", induisant que la résistance R' se retrouve connectée entre deux valeurs de potentiel identiques (ici +5V).

On n'observe donc aucune circulation de courant dans R', ce qui permet de confirmer que le fusible "Fⱼ" a bien disjoncté, et que le circuit de test est bien désactivé.

## Revendications

1. Circuit intégré comprenant au moins une entrée externe, une alimentation, et une pluralité de composants élémentaires (C₁, C₂, C₃, C₄) présentant chacun au moins une entrée interne et au moins une sortie interne,
**caractérisé en ce qu'**il comprend au moins une unité de test comprenant une porte ET, dont chaque entrée est connectée à une sortie interne d'un desdits composants élémentaires (C1, C2, C3, C4) et dont la sortie est reliée à ladite alimentation, via une résistance (R), et **en ce que** lesdites sorties internes connectées auxdites entrées de la porte ET sont sélectionnées de façon que ladite porte ET délivre un « 1 » si lesdits composants élémentaires sont conformes, dans une configuration de test dans laquelle une séquence de test prédéterminée est injectée via la ou lesdites entrées externes.

2. Circuit intégré selon la revendication 1, **caractérisé en ce qu'**au moins une desdites entrées de la porte ET présente un inverseur, de façon que l'ensemble desdites entrées valent « 1 » dans ladite configuration de test.

3. Circuit intégré selon l'une quelconque des revendications 1 à 2, **caractérisé en ce qu'**il comprend au moins deux unités de test, associées chacune à une zone distincte(Z1, Z2, Zn) dudit circuit.

4. Circuit intégré selon la revendication 3, **caractérisé en ce que** lesdites entrées de chacune desdites unités de test sont préselectionnées de façon qu'une configuration de test dédiée soit associée à chaque unité de test, pour permettre un test indépendant de chacune desdites zones.

5. Circuit intégré selon l'une quelconque des revendications 1 à 4, **caractérisé en ce qu'**il comprend des moyens d'inactivation de la ou desdites unités de test.

6. Circuit intégré selon la revendication 5, **caractérisé en ce qu'**au moins un desdits moyens d'inactivation d'au moins une desdites unités de test comprend une porte OU, dont une première entrée interne est connectée à la sortie de la porte ET de ladite unité de test, une seconde entrée interne est connectée à un signal de commande d'inactivation (TD), et la sortie est connectée à ladite résistance (R).

7. Circuit intégré selon la revendication 6, **caractérisé en ce que** ledit signal de commande d'inactivation (TD) est délivré par un fusible interne (Fj), qui disjoncte une fois pour toute à réception d'un signal de disjonction délivré par la sortie d'une porte ET d'inactivation, dont les entrées reçoivent une séquence prédéterminée d'inactivation de test.

8. Circuit intégré selon la revendication 7, **caractérisé en ce qu'**il comprend des moyens de vérification d'inactivation de test comprenant une porte ET dont les entrées sont connectées aux bornes dudit fusible (Fj), et la sortie est reliée à ladite alimentation, via une seconde résistance (R').

9. Procédé de test d'un circuit intégré réalisé selon l'une quelconque des revendications 1 à 8, **caractérisé en ce qu'**il comprend une phase de test comprenant, pour au moins une unité de test, les étapes suivantes :
- envoi d'une séquence de test prédéterminée via au moins une desdites entrées externes dudit circuit intégré ;
- observation du courant dans ladite résistance ;
- décision de conformité délivrant une information de conformité ou de non conformité pour ladite zone, en fonction de ladite observation.

10. Procédé de test d'un circuit selon la revendication 9, **caractérisé en ce que** ladite phase de test est mise en oeuvre successivement pour chaque zone dudit circuit et **en ce qu'**il délivre une information de conformité globale pour ledit circuit ou une information de non conformité désignant au moins une zone défaillante dudit circuit.

11. Procédé de test d'un circuit selon l'une quelconque des revendications 9 et 10, **caractérisé en ce qu'**il comprend une étape d'inactivation de test permettant de neutraliser la consommation de courant dans ladite résistance, après ladite phase de test.

12. Procédé de test d'un circuit selon la revendication 11, **caractérisé en ce que** ladite étape d'inactivation comprend une étape d'envoi d'une séquence d'inactivation.

13. Procédé de test d'un circuit selon la revendication 12, **caractérisé en ce qu'**il comprend une étape de vérification d'inactivation de test comprenant les sous-étapes suivantes :
- répétition de ladite étape d'inactivation de test,
- observation du courant dans une seconde résistance.

14. Système de test d'un circuit intégré **caractérisé en ce qu'**il comprend :
- un circuit intégré selon l'une quelconque des revendications 1 à 8 ;
- un dispositif de test d'un circuit intégré selon l'une quelconque des revendications 1 à 8, comprenant, pour une unité de test correspondant à une desdites zones dudit circuit, des moyens de test comprenant :
- des moyens d'envoi d'une séquence de test prédéterminée via au moins une desdites entrées externes dudit circuit intégré ;
- des moyens d'observation du courant dans ladite résistance ;
- des moyens de décision de conformité délivrant une information de conformité ou de non conformité pour ladite zone, en fonction de ladite observation.

15. Produit programme d'ordinateur téléchargeable depuis un réseau de communication et/ou stocké sur un support lisible par ordinateur et/ou exécutable par un microprocesseur, **caractérisé en ce qu'**il comprend des instructions de code de programme pour l'exécution du procédé de test selon l'une au moins des revendications 9 à 13.

## Claims

1. Integrated circuit comprising at least one external input, one power supply and a plurality of elementary components (C₁, C₂, C₃, C₄) each having at least one internal input and at least one internal output,
**characterised in that** it comprises at least one test unit comprising an AND gate, each input of which is connected to an internal input of one of said elementary components (C1, C2, C3, C4), and the output of which is connected to said power supply, via a resistor (R), and **in that** said internal outputs connected to said inputs of the AND gate are selected such that said AND gate delivers a "1" if said elementary components are in conformity, in a test configuration in which a predetermined test sequence is injected via said external output or outputs.

2. Integrated circuit of claim 1, **characterised in that** at least one of said inputs of the AND gate has an inverter, so that all of said inputs equal "1" in said test configuration.

3. Integrated circuit as claimed in any of claims 1 to 2, **characterised in that** it comprises at least two test units, each associated with a separate zone (Z1, Z2, Zn) of said circuit.

4. Integrated circuit of claim 3, **characterised in that** said inputs of each of said test units are preselected such that a dedicated test configuration is associated with each test unit, in order to enable independent testing of each of said zones.

5. Integrated circuit as claimed in any of claims 1 to 4, **characterised in that** it comprises means of deactivating said test unit or test units.

6. Integrated circuit of claim 5, **characterised in that** at least one of said means of deactivating at least one of said test units comprises an OR gate, a first internal output of which is connected to the output of the AND gate of said test unit, a second internal output of which is connected to a deactivation command signal (TD), and the output of which is connected to said resistor (R).

7. Integrated circuit of claim 6, **characterised in that** said deactivation command signal (TD) is delivered by an internal fuse (Fj), which permanently disconnects upon receiving a disconnect signal delivered by the output of a deactivation AND gate, the inputs of which receive a predetermined test deactivation sequence.

8. Integrated circuit of claim 7, **characterised in that** it comprises test deactivation verification means comprising an AND gate the inputs of which are connected to the terminals of said fuse (Fj), and the output of which is connected to said power supply, via a second resistor (R').

9. Method of testing an integrated circuit produced as claimed in any of claims 1 to 8, **characterised in that** it comprises a test phase which, for at least one test unit, comprises the following steps:
- sending a predetermined test sequence via at least one of said external inputs of said integrated circuit;
- observation of the current in each resistor;
- a conformity decision which delivers conformity or non-conformity information for each zone, on the basis of said observation.

10. Method of testing a circuit of claim 9, **characterised in that** said test phase is implemented successively for each zone of said circuit, and **in that** it delivers global conformity information for each circuit, or non-conformity information designating at least one faulty zone of said circuit.

11. Method of testing a circuit as claimed in any of claims 9 and 10, **characterised in that** it comprises a test deactivation step for neutralising the current consumption in said resistor, after said test phase.

12. Method of testing a circuit of claim 11, **characterised in that** said deactivation step comprises a step of sending a deactivation sequence.

13. Method of testing a circuit of claim 12, **characterised in that** it comprises a test deactivation verification step, comprises the following steps:
- repetition of said test deactivation step,
- observation of the current in a second resistor.

14. Integrated circuit testing system, **characterised in that** it comprises:
- an integrated circuit as claimed in any of claims 1 to 8;
- an integrated circuit testing device as claimed in any of claims 1 to 8, which, for a test unit corresponding to one of said zones of said circuit, comprises testing means comprising:
- means of sending a predetermined test sequence via at least one of said external inputs of said integrated circuit;
- means of observing the current in said resistor;
- conformity decision means delivering conformity or non-conformity information for each zone, on the basis of said observation.

15. Computer software package downloadable from a communication network and/or stored on a machine-readable medium and/or executable by a microprocessor, **characterised in that** it comprises program code instructions for executing the test method as claimed in at least one of claims 9 to 13.

## Patentansprüche

1. Integrierter Schaltkreis, der mindestens einen Außeneingang, eine Versorgung sowie eine Vielzahl elementarer Komponenten (C1, C2, C3, C4) aufweist, mit jeweils mindestens einem internen Eingang und einem internen Ausgang,
**dadurch gekennzeichnet, dass** der Schaltkreis mindestens eine Testeinheit mit einem UND-Gatter umfasst, von dem jeder Eingang mit einem internen Ausgang einer der besagten elementaren Komponenten (C1, C2, C3, C4) verbunden ist und deren Ausgang mit der besagten Versorgung über einen Widerstand (R) verbunden ist und **dadurch**, dass die mit den besagten Eingängen des UND-Gatters verbundenen besagten internen Ausgänge so gewählt sind, dass das besagte UND-Gatter eine "1" bereitstellt, wenn die besagten elementaren Komponenten in einer Testkonfiguration sich entsprechen bzw. konform sind, in der eine vorab festgelegte Testfolge über dem besagten externen Eingang bzw. über die besagten externen Eingänge injiziert bzw. eingegeben wird.

2. Integrierter Schaltkreis nach Anspruch 1, **dadurch gekennzeichnet, dass** mindestens eines der besagten Eingänge des UND-Gatters einen Inverter aufweist, so dass die Menge der besagten Eingänge bzw. alle dieser Eingänge den Wert "1" in der besagten Testkonfiguration einnimmt.

3. Integrierter Schaltkreis nach einem der Ansprüche 1 bis 2, **dadurch gekennzeichnet, dass** er mindestens zwei Testeinheiten aufweist, die jeweils mit einer verschiedenen Zone (Z1, Z2, Zn) des besagten Schaltkreises zusammenhängt.

4. Integrierter Schaltkreis nach Anspruch 3, **dadurch gekennzeichnet, dass** die besagten Eingänge einer jeden besagten Testeinheit so vorgewählt sind, dass eine dedizierte Testkonfiguration mit einer jeden Testeinheit zusammenhängt, um ein unabhängiges Testen einer jeden der besagten Zonen zu ermöglichen.

5. Integrierter Schaltkreis nach einem der Ansprüche 1 bis 4, **dadurch gekennzeichnet, dass** er über Mittel zum Inaktivieren der besagten Testeinheit(en) verfügt.

6. Integrierter Schaltkreis nach Anspruch 5, **dadurch gekennzeichnet, dass** mindestens eines der besagten Mittel zum Inaktivieren von mindestens einer der besagten Testeinheiten ein ODER-Gatter aufweist, von dem ein erster interner Eingang mit dem Ausgang des UND-Gatters der besagten Testeinheit verbunden ist, ein zweiter interner Eingang mit einem Signal zum Steuern der Inaktivierung (TD) verbunden ist und der Ausgang mit dem besagten Widerstand (R) verbunden ist.

7. Integrierter Schaltkreis nach Anspruch 6, **dadurch gekennzeichnet, dass** das besagte Signal zum Steuern der Inaktivierung (TD) durch eine interne Sicherung (Fj) bereitgestellt wird, die ein für allemal beim Empfang eines vom Ausgang eines Inaktivierungs-UND-Gatters bereitgestellten Abschaltsignals das Abschalten auslöst, wobei die Eingänge des Inaktivierungs-UND-Gatters eine vorgegebene Testinaktivierungsfolge empfangen.

8. Integrierter Schaltkreis nach Anspruch 7, **dadurch gekennzeichnet, dass** er über Mittel zum Prüfen der Testinaktivierung verfügt, die ein UND-Gatter umfassen, dessen Eingänge mit den Anschlüssen der besagten Sicherung (Fj) verbunden und dessen Ausgang mit der besagten Versorgung über einen zweiten Widerstand (R') verbunden sind.

9. Testverfahren eines nach einem der Ansprüche 1 bis 8 ausgeführten integrierten Schaltkreises, **dadurch gekennzeichnet, dass** es eine Testphase umfasst, welche für mindestens eine Testeinheit die folgenden Schritte aufweist:
- Senden einer vorgegebenen Testfolge über mindestens einen der besagten externen Eingänge des besagten integrierten Schaltkreises;
- Beobachtung des Stromes im besagten Widerstand;
- Konformitätsentscheidung, die eine Information über Konformität oder Nichtkonformität für die besagte Zone als Funktion der besagten Beobachtung liefert.

10. Testverfahren eines Schaltkreises nach Anspruch 9, **dadurch gekennzeichnet, dass** die besagte Testphase nacheinander für jede Zone des besagten Schaltkreises ausgeführt wird und **dadurch**, dass es eine Information über die globale Konformität für den besagten Schaltkreis oder eine Information über die Nichtkonformität liefert, welche mindestens eine versagende Zone des besagten Schaltkreises angibt.

11. Testverfahren eines Schaltkreises nach einem der Ansprüche 9 oder 10, **dadurch gekennzeichnet, dass** es einen Testinaktivierungsschritt aufweist, der das Neutralisieren des Stromverbrauchs im besagten Widerstand nach der besagten Testphase ermöglicht.

12. Testverfahren eines Schaltkreises nach Anspruch 11, **dadurch gekennzeichnet, dass** der besagte Inaktivierungsschritt einen Schritt umfasst, bei dem eine Inaktivierungsfolge gesendet wird.

13. Testverfahren eines Schaltkreises nach Anspruch 12, **dadurch gekennzeichnet, dass** es einen Schritt zum Prüfen der Testinaktivierung mit den folgenden Unterschritten umfasst:
- Wiederholung des besagten Testinaktivierungsschrittes,
- Beobachtung des Stroms in einem zweiten Widerstand.

14. Testsystem eines integrierten Schaltkreises, **dadurch gekennzeichnet, dass** es folgendes umfasst:
- einen integrierten Schaltkreis nach einem der Ansprüche 1 bis 8;
- ein Testverfahren eines integrierten Schaltkreises nach einem der Ansprüche 1 bis 8, das für eine, einer der besagten Zonen des besagten Schaltkreises entsprechenden Testeinheit, über Testmittel verfügt, welche folgendes aufweisen:
- Mittel zum Senden einer vorgegebenen Testfolge über mindestens einen der besagten externen Eingänge des besagten integrierten Schaltkreises;
- Mittel zum Beobachten des Stroms im besagten Widerstand;
- Mittel zur Konformitätsentscheidung, welche eine Information zur Konformität oder Nichtkonformität für die besagte Zone als Funktion der besagten Beobachtung liefert.

15. Computerprogramm, welches als Produkt aus einem Kommunikationsnetzwerk heruntergeladen werden kann und/oder auf einem Datenträger gespeichert ist, das von einem Rechner ablesbar ist und/oder von einem Mikroprozessor ausgeführt werden kann, **dadurch gekennzeichnet, dass** es über Programmcodeanweisungen zum Ausführen des Testverfahrens nach mindestens einem der Ansprüche 9 bis 13 verfügt.
